# EUROPEAN PATENT SPECIFICATION

(11) **EP 0 974 685 B1**
(45) Date of publication and mention of the grant of the patent: **03.12.2003**
(21) Application number: 98305915.5
(22) Date of filing: 24.07.1998
(51) Int. Cl.: C25D 5/14, H05K 3/38

(54) **Method for making a metal foil with improved bonding to substrates**
Verfahren zur Herstellung einer Metallfolie mit verbesserten Hafteigenschaften an Substraten
Procédé de fabrication d'une feuille métallique ayant une adhésion améliorée aux substrates

(43) Date of publication of application: 26.01.2000
(73) Proprietor: GA-TEK, Inc. (doing business as Gould Electronics Inc.), Eastlake, Ohio 44095-4001 (US)
(72) Inventor: Lee, Chin-Ho, Lyndhurst, Ohio 44124 (US); Haines, Ronald K., Mentor, Ohio 44060 (US); Czapor, Edward, Parma, Ohio 44129 (US)
(74) Representative: Mallalieu, Catherine Louise

(56) References cited:
- EP-A- 0 353 766
- EP-A- 0 520 640
- FR-A- 1 508 435
- US-A- 3 703 448
- DATABASE WPI Section Ch, Week 7921 Derwent Publications Ltd., London, GB; Class L03, AN 79-39898B XP002087970 & JP 54 048645 A (NIPPON DENKI KK) , 17 April 1979

## Description

The present invention provides a method of treating metal foil. In particular, the present invention involves treating metal foil in which the processing waste is easily waste-treatable while the resultant treated metal foils maintain or have improved bonding characteristics.

Metal foil, for example copper foil, is often laminated to a substrate. Resultant laminates are subjected to numerous processing techniques as well as inevitable wear and tear. In this connection, it is desirable to provide a laminate having high peel strength. High peel strength enables a laminate to maintain its structural integrity during processing (exposure to chemicals and various etchants) and over the course of normal wear and tear (heat degradation, physical agitation, and so forth).

Metal foils are typically treated to increase surface roughness and thereby increase the peel strength of resultant laminates. However, metal foils having increasingly high levels of surface roughness are subject to "treatment transfer", which is the undesirable migration of metal material from the metal foil to a dielectric substrate. Treatment transfer lowers the peel strength as well as degrading the insulating properties of the dielectric substrate. Treatment transfer also leads to unsightly yellow staining after the metal foil is etched. Accordingly, it is desirable to provide metal foil which not only exhibits high peel strength when incorporated into a laminate, but also does not affect the insulating properties of the dielectric substrate.

Since ammonium ions complex with metal ions when both are in solution, an increased concentration of ammonium ions in a given solution increases the solution's ability to solubilize metal ions. Solutions containing metal ions constitute waste which must be treated before being discarded. Generally, the higher the complexed metal ion concentration in a waste solution, the more difficult it is to treat the waste solution. It is therefore desirable to provide processes generating waste streams which are easy to treat.

The present invention relates to a method of treating metal foil, comprising sequentially: contacting a metal foil with an acidic solution; placing the metal foil in a nickel treatment bath and applying a current through the nickel treatment bath, wherein the nickel treatment bath comprises at least two plating zones, 1 to 50 g/l of an ammonium salt, and 10 to 100 g/l of a nickel compound; and applying a nickel flash layer to the metal foil under conditions such that the nickel flash layer has a fine grain structure when compared to the grain structure of the metal foil or the nickel treatment layer; and applying an adhesion promoting layer for further enhancing adhesion between the foil and the substrate.

In one embodiment, the present invention relates to a method of treating metal foil, involving sequentially contacting a metal foil with an acidic solution; placing the metal foil in a nickel treatment bath and applying a current through the nickel treatment bath, wherein the nickel treatment bath contains at least about two plating zones, 1 to 50 g/l of ammonium chloride, and 10 to 100 g/l of nickel chloride; and applying a nickel flash layer to the metal foil in an electrodeposition bath.

In another embodiment, the present invention relates to a method of treating metal foil, involving sequentially contacting a metal foil with an acidic solution, wherein the metal foil does not contain a copper treatment layer; placing the metal foil in a nickel treatment bath and applying a current through the nickel treatment bath, wherein the nickel treatment bath contains at least two plating zones, 25 to 45 g/l of an ammonium salt, and 10 to 100 g/l of a nickel compound; and applying a nickel flash layer to the metal foil in an electrodeposition bath.

As a result of the present invention, it is possible to provide metal foil which exhibits high peel strength and little or no treatment transfer when incorporated into a laminate. The present invention provides methods and foils generating increasingly treatable waste because its waste solutions contain relatively low concentrations of complexed metal ions.

Various preferred features and embodiments of the present invention will now be described by way of non-limiting example.

The metal foil used with this invention is preferably an electrically conductive foil with copper and copper-based alloy foils being especially preferred. Other examples include aluminum, nickel, tin, silver, gold and alloys thereof. The metal foils are made using one of two techniques. Wrought or rolled metal foil is produced by mechanically reducing the thickness of a copper or copper alloy strip or ingot by a process such as rolling. Electrodeposited foil is produced by electrolytically depositing metal ions, such as copper ions, on a rotating cathode drum and then peeling the deposited strip from the cathode. Electrodeposited copper foils are especially preferred.

The metal foils typically have nominal thicknesses ranging from 0.0002 inch to 0.02 inch (0.000005-0.0005 cm). Metal foil thickness is sometimes expressed in terms of weight and typically the foils of the present invention have weights or thicknesses ranging from 1/8 to 14 oz/ft² (to convert from 02/ft² to kg/m² multiply by 0.3). Especially useful metal foils are those having weights of 1/2, 1 or 2 oz/ft², and in particular, copper foil having weights of 1/2, 1 or 2 oz/ft².

Electrodeposited metal foils have a smooth or shiny (drum) side and a rough or matte (metal deposit growth front) side. The side or sides of the metal foil (electrodeposited or wrought) which may be treated in accordance with the invention can be the rough or matte side, shiny side, or both sides. The sides may be a "standard-profile surface," "low-profile surface" or "very-low-profile surface." Especially preferred embodiments involve the use of foils with matte surfaces and standard-profile surfaces. The term "standard-profile surface" is used herein to refer to a foil surface having an Rₜₘ of 7 microns to 12 microns (to convert from microns to metre multiply by 1x10⁻⁶). The term "low-profile surface" refers to a foil surface having an Rₜₘ of 7 microns or less. The term "very-low-profile surface" refers to a foil surface having an Rₜₘ of 4 microns or less. Rₜₘ is the mean of the maximum peak-to-valley vertical measurement from each of five consecutive sampling measurements, and can be measured using a Surtronic 3 profilometer marketed by Rank Taylor Hobson, Ltd., Leicester, England.

In one embodiment, the metal foils of the present invention may be characterized by the absence of any added surface roughening treatment on the base surface of the side or sides on which the inventive method is practiced. The term "base surface" of a side of foil refers to a raw foil surface which has not been subjected to any subsequent treatments of the type discussed below for refining or enhancing foil properties and/or increasing surface roughness. The term "added surface roughening" refers to any treatment performed on the base surface of the foil for the purpose of increasing the roughness of the surface of the foil not in accordance with the inventive method. In one embodiment, added surface roughening increases the Rₜₘ by 3 microns or more; and in another embodiment, added surface roughening increases the Rₜₘ by 10 microns or more.

In one embodiment, metal treatments such as copper treatments that add surface roughness are excluded from the inventive methods. Metal treatments include copper or zinc deposited electrolytically in nodular or dendritic form, and copper oxide which grows in nodular or dendritic form on the base surface of the foil. Metal foil having a naturally occurring relatively rough layer (saw-tooth shape) on the matte side of its base surface is not excluded from being within the scope of the present invention.

In one embodiment, mechanical roughness imparted to wrought metal foil during rolling or by subsequent abrasion which increases roughness beyond that of a standard profile surface is considered to be an added surface roughening treatment and is therefore excluded in accordance with the invention. In one embodiment, roughness imparted to an electrodeposited metal foil during electrodeposition which increases roughness beyond that of a standard profile surface is considered to be an added surface roughening. In one embodiment, any roughness imparted to the base surface of a metal foil that increases the roughness of said foil beyond that of a standard profile surface is considered to be added surface roughening. In one embodiment, any roughness imparted to the base surface of a metal foil that increases the roughness of said foil beyond that of a low-profile surface is considered to be added surface roughening. In one embodiment, any roughness imparted to the base surface of a metal foil that increases the roughness of said foil beyond that of a very low-profile surface is considered to be added surface roughening.

In one embodiment, the base surface of the side or sides of the metal foil is untreated prior to being subjected to the inventive method. The term "untreated" is used herein to refer to the base surface of a metal foil that has not undergone subsequent treatment for the purpose of refining or enhancing the foil properties and/or increasing surface roughness. In one embodiment, the untreated foils have a naturally occurring, non-dendritic or non-nodular layer of copper oxide or another metal or metal alloy adhered to the base surface thereof. The naturally occurring non-dendritic layer is not an added metal treatment.

In one embodiment, the base surface of the side or sides of the foil is treated, prior to being subjected to the inventive method, with one or more surface treatment layers for the purpose of refining or enhancing the foil properties, but not to add surface roughness. Any side of the foil which is not subjected to the inventive method can, optionally, also have one or more of such treatment layers applied to it. These surface treatments are known in the art.

For example, the surface treatments include the application of a metal layer which does not increase the surface roughness wherein the metal is indium, zinc, tin, nickel, cobalt, copper-zinc alloy, copper-tin alloy, and mixtures of two or more thereof, prior to practicing the inventive method. Metal layers of this type are sometimes referred to as barrier layers. These metal layers preferably have thicknesses in the range of 0.01 to 1 micron, more preferably 0.05 to 0.1 micron.

The surface treatments also include the application of a metal layer which does not increase the surface roughness wherein the metal is tin, chromium-zinc mixture, nickel, molybdenum, aluminum, or a mixture of two or more thereof, prior to practicing the inventive method. Metal layers of this type are sometimes referred to as stabilization layers. These stabilization layers can be applied to the base surface of the foil, or they can be applied to a previously applied barrier layer. These stabilization layers preferably have thicknesses in the range of 0.005 to 0.05 micron, more preferably 0.01 to 0.02 micron.

In one embodiment, one or both sides of the foil are first treated with at least one barrier layer. In another embodiment, one or both sides of the foil are first treated with at least one stabilization layer. In yet another embodiment, one or both sides of the foil are first treated with at least one barrier layer, then at least one of the treated sides is treated with at least on stabilization layer prior to practicing the inventive method.

The metal foil in accordance with this invention can be a single layer metal foil, such as a copper foil, an aluminum foil or a nickel foil, or a foil of metal alloy. The metal foil in accordance with this invention can be a foil containing multiple layers of a metal or metal alloy, such as a foil made of layers of copper and brass. There is no particular limit to the number of metal layers in any given metal foil.

The inventive method involves sequentially performing at least three steps. First, a metal foil is contacted with an acidic solution. The metal foil is subsequently subjected to a nickel treatment step. Afterwards, a nickel flash layer is applied to the metal foil. The term "sequentially" means that the three steps are performed in the order listed. That is, the nickel treatment step must be performed after contacting the metal foil with an acidic solution and before applying a nickel flash layer. However, the three steps do not necessarily have to be performed immediately after each other as additional steps may be practiced. For instance, a rinsing step may be performed after a metal foil is contacted with the acidic solution but before the metal foil is subjected to the nickel treatment step. Thus, the term "sequentially" refers to the three essential steps of the inventive method, not to any additional steps in various embodiments of the inventive method.

The first step of the inventive method involves contacting the metal foil with an acidic solution. An acidic solution has a pH of less than 5, and preferably less than 3, and more preferably less than 2. The acidic solution contains an acid and a solvent such as water, polar organic liquids such as alcohols and glycols, and mixtures thereof.

Contacting the metal foil with the acidic solution serves to remove surface oxides from the metal foil and otherwise clean the surface of the metal foil. Debris, which can deleteriously interfere with the subsequent nickel treatment step, are removed by the acidic solution. The acidic solution also serves to activate the surface of the metal foil which, in turn, facilitates subsequent treatment steps. In particular, the effectiveness of the subsequent nickel treatment step is increased by contacting the metal foil with the acidic solution. The metal foil is in contact with the acidic solution for a time sufficient to clean the metal foil, generally from 1 second to 2 minutes, preferably from 10 seconds to 40 seconds.

The metal foil is contacted with the acidic solution via any conventional means including but not limited to dipping, spraying, wiping, immersing and the like. In a preferred embodiment, the metal foil is immersed in the acidic solution. In another preferred embodiment, the temperature of the acidic solution is from about 20°C to 60°C, and more preferably from 30°C to 40°C.

The acidic solution contains at least one acid and a suitable solvent, which is typically water, although polar organic liquids can be used, or combinations of water and polar organics. Either inorganic or organic acids can be used, but inorganic acids are preferred. Specific examples of inorganic acids which may be utilized in the acidic solution include halogen acids such as hydrofluoric acid, hydrochloric acid, hydrobromic acid and hydriodic acid, sulfuric acid, sulfurous acid, nitric acid, perchloric acid, boric acid and phosphorus acids such as phosphorous acid and phosphoric acid, and combinations thereof. Nitric acid and sulfuric acid are preferred inorganic acids. Examples of organic acids include carboxylic and polycarboxylic acids such as formic acid, acetic acid, propionic acid, citric acid, oxalic acid, etc.; organic phosphorus acids such as dimethylphosphoric acid and dimethylphosphinic acid; or sulfonic acids such as methanesulfonic acid, ethanesulfonic acid, 1-pentanesulfonic acid, 1-hexanesulfonic acid, 1-heptanesulfonic acid, benzenesulfonic acid, toluenesulfonic acid, etc, and combinations thereof.

In a preferred embodiment, after the metal foil has contacted the acidic solution, the metal foil is optionally rinsed with a neutral or slightly alkaline solution, and in most instances an aqueous based solution such as water optionally with a buffer. The neutralizing or rinsing solution serves to remove excess acid and/or debris from the surface of the metal foil.

After the metal foil has contacted the acidic solution, the metal foil is subjected to a nickel treatment step. This step is conducted by placing the metal foil in a nickel treatment bath and applying a current through the nickel treatment bath. The nickel treatment step changes the conformation of the surface of the metal foil. More specifically, the nickel treatment step increases the surface area by forming nodules or dendrites on the surface of the metal foil.

The nickel treatment bath contains an ammonium salt, a nickel compound and a suitable solvent. The solvent is typically aqueous based, although polar organic solvents may be used. Ammonium salts include quaternary organic ammonium salts such as tetramethylammonium chloride and tetraethylammonium chloride, as well as ammonium chloride, ammonium bromide, ammonium benzoate, ammonium carbonate, ammonium dihydrogen phosphate, ammonium fluoride, ammonium hydrogen carbonate, ammonium iodide, ammonium nitrate, ammonium phosphate, ammonium sulfate, and ammonium bisulfate. The ammonium salt is present in an amount from 1 to 50 g/l, and preferably 25 to 45 g/l, and most preferably 30 to 40 g/l. It is an important aspect of the inventive method that the amount of ammonium salt in the nickel treatment bath does not exceed 50 g/l, and desirably does not exceed 45 g/l. Ammonium ions can be difficult to dispose of as waste. Moreover, the higher the ammonium ion concentration, the higher the metal ion solubility through complexation thereby making ammonium waste more dangerous and/or difficult to treat.

The nickel compound is any compound containing nickel which is capable of dissociating in a solution, such as a nickel salt. Nickel compounds include nickel chloride, nickel bromide, nickel acetate, nickel carbonate, nickel fluoride, nickel iodide, nickel nitrate, nickel oxide, and nickel sulfate. Nickel chloride is preferably used. The nickel compound is present in the nickel treatment bath in an amount from 10 to 100 g/l, and preferably from 20 to 60 g/l, and most preferably from 30 to 50 g/l.

In one embodiment, the current density applied to the nickel treatment bath is from 150 to 500 ASF (1,666-5,555 amps/m²). In another embodiment, the current density is from 200 to 400 ASF (2,222-4,444 amps/m²), and preferably from 250 to 300 ASF (2,777-3,333 amps/m²). In one embodiment, the temperature of the nickel treatment bath is from 20°C to 50°C. In another embodiment, the temperature is from 25°C to 45°C, and preferably from 30°C to 40°C. In one embodiment, the pH of the nickel treatment bath is from 4 to less than 7. In another embodiment, the pH is from 5 to 6.5, and preferably from 5.5 to 6. The metal foil is placed in the nickel treatment bath for a time sufficient to permit the formation of nodules on the surface. In one embodiment, the metal foil is placed in the nickel treatment bath from 10 to 60 seconds. In a preferred embodiment, the metal foil is in the nickel treatment bath from 20 to 40 seconds.

Another important aspect of the inventive method is that the nickel treatment bath contains at least about two plating zones. In a preferred embodiment, the nickel treatment bath contains at least about three plating zones, and more preferably the nickel treatment bath contains at least about four plating zones. Utilizing at least about two plating zones leads to improved peel strength in laminates using the resultant treated metal foil. Multiple plating zones contribute to a uniform application of the nickel treatment step.

In a preferred embodiment, the current density is varied as the nickel treatment step is conducted. That is, in one embodiment, the current density is temporarily maintained at a relatively high level within the acceptable range followed by adjusting the current density to a relatively low level within the acceptable range. A high-low-high-low, etc. application of current density provides a more desirable nickel treatment which, in turn, leads to higher peel strength after the treated metal foil is laminated to a substrate.

In one embodiment, the average thickness of the nickel treatment layer is from 0.5 microns to 4 microns. In a preferred embodiment, the average thickness of the nickel treatment layer is from 1.5 microns to 2.5 microns. The thickness of the nickel treatment layer can be measured by conventional automated devices.

As a result of the conditions under which the nickel treatment layer is applied to the metal foil, the nickel treatment layer has an acicular structure, especially when compared to the grain structure of the metal foil or the nickel flash layer. The acicular structure provides a non-uniform surface to the resultant treated metal foil, which in turn, leads to improved peel strength once the treated metal foil is laminated to a substrate.

In a preferred embodiment, after the nickel treatment step has been performed, the metal foil is optionally rinsed with a neutral or slightly acidic solution, and in most instances an aqueous based solution such as water optionally with a buffer. The neutralizing or rinsing solution serves to remove excess ammonium ions and/or loose debris from the surface of the metal foil.

The step involving applying a nickel flash layer to the metal foil is preferably carried out in an electrodeposition bath via electrodeposition of nickel or nickel alloy. This step is conducted after the nickel treatment step. The term "nickel flash layer" refers to a thin nickel coating having a low profile relative to the surface on which it is coated. In other words, the nickel flash layer is flat or generally non-dendritic. When applied to a dendritic surface, the nickel flash layer is fairly uniform in that it follows the contours of the nodules or dendrites wherein its thickness is substantially constant over the entire area of the metal foil which it is applied.

In one embodiment, the nickel flash layer is applied at a thickness which is less than the profile of the nodular or dendritic layer on which it is being deposited. In a more preferred embodiment, the nickel flash layer has an average thickness no greater than 20% of the average height of the nodules or dendrites on the metal foil. The average height of nodules or dendrites on the metal foil refers to the average depth of the valleys between the nodules or dendrites to the average height of the peaks of the nodules or dendrites from the metal foil. In this connection, average profile height is analogous to Rₜₘ. The average profile height may be determined in the same manner of the Rₜₘ. In a preferred embodiment, the average thickness of the nickel flash layer is no greater than 10% of the average profile height. In a more preferred embodiment, the average thickness of the nickel flash layer is no greater than 5% of the average profile height.

In one embodiment, the average thickness of the nickel flash layer is from 0.2 microns to 3 microns. In a preferred embodiment, the average thickness of the nickel flash layer is from 0.7 microns to 1.5 microns. In another preferred embodiment, the average thickness of the nickel flash layer is smaller than the average thickness of the nickel treatment layer. The thickness of the nickel flash layer can be measured by conventional automated devices.

The electrodeposition bath for applying a nickel flash layer to the metal foil contains at least one nickel compound in a suitable solvent. The electrodeposition bath may also contain various additives in order to promote the deposition of a uniform, relatively flat, non-dendritic nickel flash layer. The nickel compounds are the same as those discussed in connection with the nickel treatment bath. Nickel sulfate is a preferred nickel compound for the nickel flash electrodeposition bath. Various additives include buffers such as boric acid, flatening agents such as saccharin, and anti-pitting compounds such as a surfactant. When boric acid is present in the bath as a buffer, it is present from 10 to 100 g/l, preferably from 20 to 60 g/l, and most preferably from 30 to 50 g/l.

In a preferred embodiment, at least two nickel compounds are present in the nickel flash electrodeposition bath. In this embodiment, the nickel compounds are preferably nickel sulfate and nickel chloride. In one embodiment, the amount of nickel compounds present in the nickel flash electrodeposition bath is from 200 to 500 g/l. In a preferred embodiment, the total amount is from 250 to 450 g/l, and preferably from 300 to 400 g/l. When two or more nickel compounds are present in the nickel flash electrodeposition bath, it is preferable that the ratio of a first nickel compound to a second nickel compound is from 3:1 to 10:1, and preferably from 4:1 to 8:1.

In one embodiment, the current density appliced to the nickel flash electrodeposition bath is from 10 to 100 ASF (111-1,111 amps/m²). In another embodiment, the current density is from 20 to 90 ASF (222-1,000 amps/m²), and preferably from 40 to 80 ASF (444-888 amps/m²). In one embodiment, the current density applied to the nickel flash electrodeposition bath is less than half of the current density applied to the nickel treatment bath.

In a preferred embodiment, the current density is varied as the nickel flash layer is applied. That is, in one embodiment, the current density is temporarily maintained at a relatively high level within the acceptable range followed by adjusting the current density to a relatively low level within the acceptable range. A high-low-high-low, etc. application of current density provides a more desirable nickel flash layer which, in turn, leads to a higher quality treated metal foil.

In one embodiment, the temperature of the nickel flash electrodeposition bath is from 30°C to 80°C. In another embodiment, the temperature is from 40°C to 70°C, and preferably from 50°C to 60°C. In one embodiment, the temperature of the nickel flash electrodeposition bath is higher than the temperature of the nickel treatment bath.

In one embodiment, the pH of the nickel flash electrodeposition bath is from 2.5 to less than 5.5. In another embodiment, the pH is from 3 to 5, and preferably from 3.5 to 4.5. In one embodiment, the pH of the nickel flash electrodeposition bath is lower than the pH of the nickel treatment bath.

The metal foil is placed in the nickel flash electrodeposition bath for a time sufficient to permit the formation of a uniform, relatively flat nickel deposit on the surface. In one embodiment, the metal foil is placed in the nickel flash electrodeposition bath from 10 to 60 seconds. In a preferred embodiment, the metal foil is in the nickel flash electrodeposition bath from 20 to 40 seconds. In one embodiment, the metal foil is placed in the nickel flash electrodeposition bath for a time longer than the time the metal foil is placed in the nickel treatment bath.

In one embodiment, while applying the nickel flash layer to the metal foil, the electrodeposition bath contains at least one plating zone. In a preferred embodiment, the electrodeposition bath for plating the nickel flash layer contains at least two plating zones. In another preferred embodiment, the electrodeposition bath for plating the nickel flash layer contains at least three plating zones, and more preferably, at least four plating zones.

As a result of the conditions under which the nickel flash layer is applied to the metal foil, the nickel flash layer has a fine grain structure, especially when compared to the grain structure of the metal foil or the nickel treatment layer. The fine grain structure provides improved strength to the resultant treated metal foil, which in turn, leads to improved peel strength once the treated metal foil is laminated to a substrate.

The treated metal foils contain one or more adhesion promoting layers adapted for further enhancing adhesion between the foil and a substrate. The adhesion promoting layer may comprise at least one silane compound and/or at least one thermosetting and thermoplastic polymer and copolymer. The thermosetting and thermoplastic polymers and copolymers include epoxy resins (including monofunctional and multifunctional epoxy resins), formaldehyde resins, phenol formaldehyde resins, polyester resins, butadiene and acrylonitrile rubbers, polyvinylbutyral resins and/or phenolic resins. In one embodiment, the adhesion promoting layer is characterized by the absence of chromium intermixed therewith.

In one embodiment, the adhesion promoting layer may be made by applying one or more silane compounds to at least one side or surface of the treated metal foil. The silane compound is present in the solution in an amount from 0.1 to 10% v/v, and preferably form 0.2 to 5% v/v, and more preferably from 0.3 to 3% v/v. Preferred silane compounds are silane coupling agents. Preferred silane coupling agents are amino-silane compounds, epoxy-silane compounds, and alkoxy-silane compounds.

In one embodiment, the silane compound may be represented by the formula 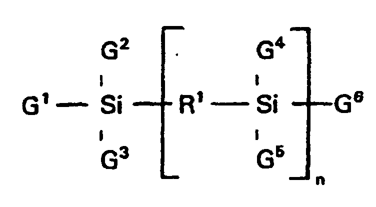 wherein G¹, G², G³, G⁴, G⁵ and G⁶ are independently halogen, hydrocarbyloxy, or hydroxy groups; R¹ is a hydrocarbon group or nitrogen-containing hydrocarbon group; and n is zero or 1. In one embodiment each of G¹, G², G³, G⁴, G⁵ and G⁶ is independently chloro, alkoxy, alkoxyalkoxy or alkoxyalkoxyalkoxy, and R¹ is an alkylene or an arene group of up to 10 carbon atoms, or a monoamino- or polyamino-substituted alkylene or arene group of up to 10 carbon atoms. In one embodiment each of G¹, G², G³ and G⁶ is an alkoxy, alkylalkoxy, alkoxyalkoxy or alkoxyalkoxyalkoxy group of up to 10 carbon atoms, and n is zero.

Examples of these silane compounds include tetramethoxysilane, tetraethoxysilane, tetrapropoxysilane, tetra-n-butoxysilane, tetrakis(2-ethoxyethoxy)silane, tetrakis(2-ethylbutoxy)silane, tetrakis(2-ethylhexoxy)silane, tetrakis(methoxyethoxyethoxy)silane, tetrakis(2-methoxyethoxy)silane, tetrakis(1-methoxy-2-propoxy)silane, bis[3-(triethoxysilyl)propyl] amine, bis[3-(trimethoxysilyl)propyl]ethylenediamine, 1,2-bis(trimethoxysilyl)ethane, bis(trimethoxysilylethyl)benzene, 1,6-bis(trimethoxysilyl)hexane, 1,2-bis(trichlorosilyl)ethane, 1,6-bis(trichlorosilyl)hexane, and 1,8-bis(trichlorosilyl)octane.

In another embodiment, the silane compound may be a compound represented by the formula 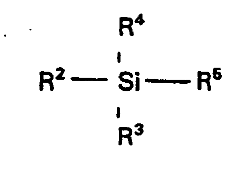 wherein R², R³, R⁴ and R⁵ are independently hydrogen, a halogen group, a hydrocarbyloxy group, a hydroxy group, an organofunctional group, the organofunctional group being reactive with or having an affinity for another substrate (such as a prepreg). Examples of organofunctional groups include amino-containing, amido-containing, hydroxy-containing, alkoxy-containing hydrocarbons, vinyl-containing hydrocarbons, aromatics, heterocyclics, allyl-containing, epoxy-containing, mercapto-containing, carboxy-containing, isocyanato-containing, glycidoxy-containing and acryloxy-containing. In one embodiment, each of R³, R⁴ and R⁵ are chloro, methoxy or ethoxy, and R² is an organofunctional group. In one embodiment, each of R⁴ and R⁵ are chloro, methoxy or ethoxy, and R² and R³ are an organofunctional groups.

Examples of these silane compounds include tetramethoxysilane; tetraethoxysilane; diaminosilane; N-(2-aminoethyl)-3-aminopropyltrimethoxysilane; 3-(N-styrylmethyl-2-aminoethylamino)propyltrimethoxysilane; 3-aminopropyltriethoxysilane; bis(2-hydroxyethyl)-3-aminopropyltriethoxysilane; β-(3,4-epoxycyclohexyl)-ethyltrimethoxysilane; 3-glycidoxypropyltrimethoxysilane; 3-methacryloxypropyltrimethoxysilane; 3-chloropropyltrimethoxysilane; vinyltrichlorosilane; vinyltriethoxysilane; vinyl-tris(2-methoxyethoxy)silane; aminopropyltrimethoxysilane; N-methylaminopropyltrimethoxysilane; N-phenylaminopropyltrimethoxysilane; 3-acetoxypropyltrimethoxysilane; N-(3-acryloxy-2-hydroxypropyl)-3-aminopropyltriethoxysilane; 3-acryloxypropyltrimethoxysilane; allyltriethoxysilane; allyltrimethoxysilane; 4-aminobutyltriethoxysilane; (aminoethylaminomethyl)phenethyltrimethoxysilane; N-(2-aminoethyl-3-aminopropyl)trimethoxysilane; N-(2-aminoethyl-3-aminopropyl)tris (2-ethylhexoxy)silane; 6-(aminohexylaminopropyl)trimethoxysilane; aminophenyltrimethoxysilane; 3-(1-aminopropoxy)-3,3-dimethyl-1-propenyltrimethoxysilane; 3-aminopropyltris(methoxyethoxyethoxy)silane; 3-aminopropyltriethoxysilane; 3-aminopropyltrimethoxysilane; ω-aminoundecyltrimethoxysilane; 3-[2-N-benzylaminoethylaminopropyl]trimethoxysilane; bis(2-hydroxyethyl)-3-aminopropyltriethoxysilane; 8-bromooctyltrimethoxysilane; bromophenyltrimethoxysilane; 3-bromopropyltrimethoxysilane; 2-chloroethyltriethoxysilane; p-(chloromethyl)phenyltrimethoxysilane; chloromethyltriethoxysilane; chlorophenyltriethoxysilane; 3-chloropropyltriethoxysilane; 3-chloropropyltrimethoxysilane; 2-(4-chlorosulfonylphenyl)ethyltrimethoxysilane; 3-(cyanoethoxy)-3,3-dimethyl-1-propenyltrimethoxysilane; 2-cyanoethyltriethoxysilane; 2-cyanoethyltrimethoxysilane; (cyanomethylphenethyl)trimethoxysilane; 3-cyanopropyltriethoxysilane; 3-cyclopentadienylpropyltriethoxysilane; (N,N-diethyl-3-aminopropyl)trimethoxysilane; diethylphosphatoethyltriethoxysilane; (N,N-dimethyl-3-aminopropyl)trimethoxysilane; 2-(diphenylphosphino)ethyltriethoxysilane; 2-(3,4-epoxycyclohexyl)ethyltrimethoxysilane; 3-iodopropyltrimethoxysilane; 3-isocyanatopropyltriethoxysilane; 3-mercaptopropyltriethoxysilane; 3-mercaptopropyltrimethoxysilane; methacryloxypropenyltrimethoxysilane; 3-methacryloxypropyltrimethoxysilane; 3-methacryloxypropyltris(methoxyethoxy)silane; 3-methoxypropyltrimethoxysilane; N-methylaminopropyltrimethoxysilane; 0-4-methylcoumarinyl-N-[3-(triethoxysilyl)propyl]carbamate; 7-oct-1-enyltrimethoxysilane; N-phenethyl-N'-triethoxysilylpropylourea; N-phenylaminopropyltrimethoxysilane; 3-(N-styrylmethyl-2-aminoethylamino)propyltrimethoxysilane; 3-thiocyanatopropyltriethoxysilane; N-(3-triethoxysilylpropyl)acetylglycinamide; N-(triethoxysilylpropyl)dansylamide; N-[3-(triethoxysilyl)propyl]-2,4-dinitrophenylamine; triethoxysilylpropylethylcarbamate; N-[3-(triethoxysilyl)-propyl]-4,5-dihydroimidazole; N-triethoxysilylpropyl-o-menthocarbamate; 3-(triethoxysilylpropyl)-p-nitrobenzamide; N-[3-(triethoxysilyl)propyl]phthalamic acid; N-(triethoxysilylpropyl)urea; 1-trimethoxysilyl-2-(p,m-chloromethyl)-phenylethane; 2-(trimethoxysilyl)ethylphenylsulfonylazide; β-trimethoxysilylethyl-2-pyridine; trimethoxysilyloctyltrimethylammonium bromide; trimethoxysilylpropylcinnamate; N(3-trimethoxysilylpropyl)-N-methyl-N,N-diallylammonium chloride; trimethoxysilylpropyldiethylenetriamine; N-[(3-trimethoxysilyl)propyl]ethylenediaminetriacetic acid trisodium salt; trimethoxysilylpropylisothiouronium chloride; N-(3-trimethoxysilylpropyl) pyrrole; N-trimethoxysilylpropyltri-N-butylammonium bromide; N-trimethoxysilylpropyl-N,N,N-trimethylammonium chloride; vinyltriethoxysilane; vinyltriisopropoxysilane; vinyltrimethoxysilane; vinyltris-t-butoxysilane; vinyltris(2-methoxyethoxy)silane; vinyltriisopropenoxysilane; vinyltris(t-butylperoxy)silane; 2-acetoxyethyltrichlorosilane; 3-acryloxypropyltrichlorosilane; allyltrichlorosilane; 8-bromooctyltrichlorosilane; bromophenyltrichlorosilane; 3-bromopropyltrichlorosilane; 2-(carbomethoxy)ethyltrichlorosilane; 1-chloroethyltrichlorosilane; 2-chloroethyltrichlorosilane; p-(chloromethyl)phenyltrichlorosilane; chloromethyltrichlorosilane; chlorophenyltrichlorosilane; 3-chloropropyltrichlorosilane; 2-(4-chlorosulfonylphenyl)ethyltrichlorosilane; (3-cyanobutyl)trichlorosilane; 2-cyanoethyltrichlorosilane; 3-cyanopropyltrichlorosilane; (dichloromethyl)trichlorosilane; (dichlorophenyl)trichlorosilane; 6-hex-1-enyltrichloro silane; 3-methacryloxypropyltrichlorosilane; 3-(4-methoxyphenyl)propyltrichlorosilane; 7-oct-1-enyltrichlorosilane; 3-(N-phthalimido)propyltrichlorosilane; 1-trichlorosilyl-2-(p,m-chloromethylphenyl)ethane; 4-[2-(trichlorosilyl)ethyl]cyclohexene; 2-[2-(trichlorosilyl)ethyl]pyridine; 4-[2-(trichlorosilyl)ethyl]pyridine; 3-(trichlorosilyl)propylchloroformate; and vinyltrichlorosilane.

In one embodiment, preferred silanes include 3-aminopropyltriethoxysilane; 3-glycidoxypropyltrimethoxysilane; and N-[-3(triethoxysilyl)propyl]-4,5-dihydroimidazole. Mixtures of two or more of the silane compounds listed above may be used. For example, in one embodiment, the silane compound is N-(2-aminoethyl-3-aminopropyl)trimethoxysilane, 3-aminopropyltrimethoxysilane or 3-glycidoxypropyltrimethoxysilane in combination with tetraethoxysilane or tetramethoxysilane.

The silane solution may be in the form of a dispersion or solution in water, a mixture of water and alcohol, or a suitable organic solvent, or as an aqueous emulsion of the silane mixture, or as an aqueous emulsion of a solution of the silane compound in a suitable organic solvent. Conventional organic solvents may be used. These include alcohols, ethers, ketones, and mixtures of these with aliphatic or aromatic hydrocarbons or with amides such as N,N-dimethylformamide. Useful solvents are those having good wetting and drying properties and include, for example, water, ethanol, isopropanol, and methylethylketone. Aqueous emulsions of the silane compound may be formed in conventional manner using conventional dispersants and surfactants, including nonionic dispersants. The step of contacting the metal foil with the silane solution may be repeated, if desired, several times. However, a single step gives generally useful results and, hence, the use of a single step is generally preferred. Contact is accomplished via known application methods which include reverse roller coating, doctor blade coating, dipping, immersing, painting and spraying.

The silane solution is typically at a temperature of preferably 15°C to 45°C, more preferably 20°C to 30°C. After the treated metal foil is contacted with a silane solution, the metal foil can be heated to a temperature of preferably 60°C to 170°C, more preferably 90 to 150°C, for preferably 0.03 to 5 minutes, more preferably 0.2 to 2 minutes to enhance drying of the surface. The dry film thickness of the silane compound on the metal foil is preferably from 0.002 to 0.1 microns, more preferably 0.005 to 0.02 microns.

The metal foils treated in accordance with the present invention can be bonded to substrates to provide dimensional and structural stability thereto. The treated metal foils of the invention enhance the bond or peel strength between the treated metal foil and the substrate. An advantage of the treated metal foils is that these foils can avoid added copper surface roughening, yet exhibit effective bond or peel strengths with substrates. Another advantage is that metal particles for the treated metal foil are not transferred or diffused into a substrate to which it is subsequently laminated. These foils can have a standard profile surface, low-profile surface and even a very low-profile surface, and yet provide a desired peel strength. Yet another advantage of the treated metal foils is that either the matte side or shiny side can be effectively bonded to a substrate after treatment.

Useful substrates may be prepared by impregnating woven glass reinforcement materials with partially cured resins, usually epoxy resins (e.g., difunctional, tetrafunctional and multifunctional epoxies). Other useful resins include amino type resins produced from the reaction of formaldehyde and urea or formaldehyde and melamine, polyesters, phenolics, silicones, polyamides, polyimides, di-allyl phthalates, phenylsilanes, polybenizimidazoles, diphenyloxides, polytetrafluoroethylenes, cyanate esters, and the like. These substrates are sometimes referred to as dielectric substrates or prepregs.

Generally speaking, methods of making laminates are known in the art. In preparing the laminates, treated metal foil and prepreg material may be first cut into sheets and then subjected to lamination. The prepregs may consist of a woven glass reinforcement fabric impregnated with a partially cured two-stage resin. By application of heat and pressure, the treated metal foil is pressed tightly against the prepreg and the temperature to which the assemblage is subjected activates the resin to cause curing, that is crosslinking of the resin and thus tight bonding of the foil to the prepreg substrate.

The treated metal foils may be used in a myriad of possible end use applications, but generally for electronic devices or electronic related applications. These methods and end uses are known in the art.

While not intending to be so limiting, the following examples illustrate various and novel aspects of the present invention. Unless otherwise indicated, in the following examples as well as throughout the specification and claims, all parts and percentages are by weight, all temperatures are in degrees centigrade, and all pressures are atmospheric.

### Example 1

Copper foil is contacted with a dilute solution of sulfuric acid. The copper foil is then rinsed with water and advanced through an aqueous bath containing 40 g/l ammonium chloride and 40 g/l nickel chloride at 25°C for about 25 seconds under a current density of 202 ASF (2,244 amps/m²). The bath contains two plating zones. Next, the metal foil is placed in a nickel flash electrodeposition bath containing 320 g/l of nickel sulfate, 40 g/l of nickel chloride, and 30 g/l of boric acid in water. The metal foil is in the nickel flash electrodeposition bath for about 30 seconds at a temperature of 50°C under a current density of about 40 ASF (444 amps/m²). The nickel flash electrodeposition bath contains two plating zones.

### Example 2

Copper foil is contacted with a dilute solution of sulfuric acid. The copper foil is then rinsed with water and advanced through an aqueous bath containing 40 g/l ammonium chloride and 40 g/l nickel chloride at 25°C for about 25 seconds under a current density of 278 ASF (3,088 amps/m²). The bath contains four plating zones. Next, the metal foil is placed in a nickel flash electrodeposition bath containing 320 g/l of nickel sulfate, 40 g/l of nickel chloride, and 30 g/l of boric acid in water. The metal foil is in the nickel flash electrodeposition bath for about 30 seconds at a temperature of 50°C under a current density of about 40 ASF. The nickel flash electrodeposition bath contains two plating zones.

### Comparative Example 1

Copper foil is contacted with a dilute solution of sulfuric acid. The copper foil is then rinsed with water and advanced through an aqueous bath containing 40 g/l ammonium chloride and 40 g/l nickel chloride at 25°C for about 25 seconds under a current density of 202 ASF. The bath contains one plating zone. Next, the metal foil is placed in a nickel flash electrodeposition bath containing 320 g/l of nickel sulfate, 40 g/l of nickel chloride, and 30 g/l of boric acid in water. The metal foil is in the nickel flash electrodeposition bath for about 30 seconds at a temperature of 50°C under a current density of about 40 ASF. The nickel flash electrodeposition bath contains two plating zones.

### Comparative Example 2

Copper foil is contacted with a dilute solution of sulfuric acid. The copper foil is then rinsed with water and advanced through an aqueous bath containing 70 g/l ammonium chloride and 28 g/l nickel chloride at 25°C for about 35 seconds under a current density of 202 ASF. The bath contains one plating zone. Next, the metal foil is placed in a nickel flash electrodeposition bath containing 320 g/l of nickel sulfate, 40 g/l of nickel chloride, and 30 g/l of boric acid in water. The metal foil is in the nickel flash electrodeposition bath for about 35 seconds at a temperature of 50°C under a current density of about 40 ASF. The nickel flash electrodeposition bath contains two plating zones.

Each of the four treated copper foils is laminated to a General Electric FR-4 epoxy prepreg, and the peel strength is tested and reported in Table 1. Also reported in Table 1 is the metal ion waste-treatability associated with making the four copper foil laminates.

**Table 1**

| Example | Peel Strength (lb/sq in) | Metal Ion Waste Treatabilty |
|---|---|---|
| 1 | 15.6 | Good |
| 2 | 16.2-17 | Good |
| C1 | 11.8 | Good |
| C2 | 11 | Poor |

While the invention has been explained in relation to its preferred embodiments, it is to be understood that various method thereof will become apparent to those skilled in the art upon reading this specification.
Therefore, it is to be understood that the invention disclosed herein is intended to cover such modifications falling within the scope of the appended claims.

## Claims

1. A method of treating metal foil, comprising sequentially:
contacting a metal foil with an acidic solution;
placing the metal foil in a nickel treatment bath and applying a current through the nickel treatment bath, wherein the nickel treatment bath comprises at least two plating zones, 1 to 50 g/l of an ammonium salt, and 10 to 100 g/l of a nickel compound; and
applying a nickel flash layer to the metal foil under conditions such that the nickel flash layer has a fine grain structure when compared to the grain structure of the metal foil or the nickel treatment layer; and
applying an adhesion promoting layer for further enhancing adhesion between the foil and the substrate.

2. The method of claim 1, wherein the metal foil does not contain a copper treatment layer.

3. The method of claim 1 or claim 2, wherein the acidic solution comprises sulfuric acid.

4. The method of any preceding claim, wherein the nickel treatment bath comprises at least three or four plating zones.

5. The method of any preceding claim, wherein the nickel treatment bath comprises 25 to 45 g/l of the ammonium salt.

6. The method of any preceding claim, wherein the nickel compound of the nickel treatment bath comprises nickel chloride.

7. The method of any preceding claim, wherein the nickel flash layer is applied in an electrodeposition bath.

8. The method of claim 7, wherein the electrodeposition bath comprises nickel sulfate and nickel chloride.

9. The method of claim 7 or claim 8, wherein a current of 20 to 100 ASF (222-1,111 amps/m²) is applied in the electrodeposition bath.

10. The method of any one of claims 7 to 9, wherein the nickel flash layer is electrodeposited at alternating current densities.

11. The method of any preceding claim, wherein the ammonium salt comprises at least one of ammonium chloride and ammonium sulfate.

12. The method of preceding claim wherein said step of applying the adhesion promoting layer comprises applying a silane coupling agent to the metal foil after applying the nickel flash layer.

## Patentansprüche

1. Verfahren zur Behandlung von Metallfolie, das aufeinanderfolgend umfaßt:
das Inkontaktbringen einer Metallfolie mit einer sauren Lösung,
das Einbringen der Metallfolie in ein Nickel-Behandlungsbad und das Anwenden eines Stroms durch das Nickel-Behandlungsbad, wobei das Nickel-Behandlungsbad wenigstens zwei Beschichtungsbereiche, 1 bis 50 g/l eines Ammoniumsalzes und 10 bis 100 g/l einer Nickelverbindung umfaßt, und
das Auftragen einer Nickel-Flash-Schicht auf die Metallfolie unter solchen Bedingungen, daß die Nickel-Flash-Schicht eine feine Kömungsstruktur im Vergleich zu der Kömungsstruktur der Metallfolie oder der Nickel-Behandlungsschicht aufweist, und
das Auftragen einer haftungsfördernden Schicht zur weiteren Verbesserung der Haftung zwischen der Folie und dem Substrat.

2. Verfahren nach Anspruch 1, wobei die Metallfolie keine Kupfer-Behandlungsschicht enthält.

3. Verfahren nach Anspruch 1 oder Anspruch 2, wobei die saure Lösung Schwefelsäure aufweist.

4. Verfahren nach einem vorangegangenen Anspruch, wobei das Nickel-Behandlungsbad wenigstens drei oder vier Beschichtungsbereiche aufweist.

5. Verfahren nach einem vorangegangenen Anspruch, wobei das Nickel-Behandlungsbad 25 bis 45 g/l des Ammoniumsalzes umfaßt.

6. Verfahren nach einem vorangegangenen Anspruch, wobei die Nickelverbindung des Nickel-Behandlungsbads Nickelchlorid umfaßt.

7. Verfahren nach einem vorangegangenen Anspruch, wobei die Nickel-Flash-Schicht in einem elektrolytischen Abscheidungsbad aufgetragen wird.

8. Verfahren nach Anspruch 7, wobei das elektrolytische Abscheidungsbad Nickelsulfat und Nickelchlorid aufweist.

9. Verfahren nach Anspruch 7 oder Anspruch 8, wobei ein Strom von 20 bis 100 ASF (222 bis 1111 A/m²) in dem elektrolytischen Abscheidungsbad aufgebracht wird.

10. Verfahren nach einem der Ansprüche 7 bis 9, wobei die Nickel-Flash-Schicht bei alternierenden Stromdichten elektrolytisch abgeschieden wird.

11. Verfahren nach einem vorangegangenen Anspruch, wobei das Ammoniumsalz wenigstens eines unter Ammoniumchlorid und Ammoniumsulfat aufweist.

12. Verfahren nach einem vorangegangenen Anspruch, wobei der Schritt des Auftragens der haftungsfördernden Schicht das Auftragen eines Silanverbindungsmittels auf die Metallfolie nach dem Auftragen der Nickel-Flash-Schicht umfaßt.

## Revendications

1. Procédé pour le traitement d'une feuille métallique, comprenant les étapes successives consistant :
à mettre en contact une feuille métallique avec une solution acide ;
à placer la feuille métallique dans un bain de traitement au nickel et à appliquer un courant à travers le bain de traitement au nickel, le bain de traitement au nickel comprenant au moins deux zones de plaquage, 1 à 50 g/l d'un sel d'ammonium et 10 à 100 g/l d'un composé de nickel ; et
à appliquer une couche éclair de nickel à la feuille métallique dans des conditions telles que la couche éclair de nickel ait une structure à grains fins comparativement à la structure de grains de la feuille métallique ou de la couche de traitement au nickel ; et
à appliquer une couche activatrice d'adhérence pour accroître davantage l'adhérence entre la feuille et le substrat.

2. Procédé suivant la revendication 1, dans lequel la feuille métallique ne contient pas de couche de traitement au cuivre.

3. Procédé suivant la revendication 1 ou la revendication 2, dans lequel la solution acide comprend de l'acide sulfurique.

4. Procédé suivant l'une quelconque des revendications précédentes, dans lequel le bain de traitement au nickel comprend au moins trois ou quatre zones de plaquage.

5. Procédé suivant l'une quelconque des revendications précédentes, dans lequel le bain de traitement au nickel comprend 25 à 45 g/l du sel d'ammonium.

6. Procédé suivant l'une quelconque des revendications précédentes, dans lequel le composé de nickel du bain de traitement au nickel comprend du chlorure de nickel.

7. Procédé suivant l'une quelconque des revendications précédentes, dans lequel la couche éclair de nickel est appliquée dans un bain d'électrodéposition.

8. Procédé suivant la revendication 7, dans lequel le bain d'électrodéposition comprend du sulfate de nickel et du chlorure de nickel.

9. Procédé suivant la revendication 7 ou la revendication 8, dans lequel un courant de 20 à 100 ASF (222 à 1 111 amp/m²) est appliqué dans le bain d'électrodéposition.

10. Procédé suivant l'une quelconque des revendications 7 à 9, dans lequel la couche éclair de nickel est électrodéposée à des densités de courant alternées.

11. Procédé suivant l'une quelconque des revendications précédentes, dans lequel le sel d'ammonium comprend au moins un des composés consistant en chlorure d'ammonium et sulfate d'ammonium.

12. Procédé suivant l'une quelconque des revendications précédentes, dans lequel l'étape d'application de la couche activatrice d'adhérence comprend l'application d'un agent de couplage du type silane à la feuille métallique après application de la couche éclair de nickel.
